# EUROPÄISCHE PATENTANMELDUNG

(11) **EP 4 231 095 A1**
(43) Veröffentlichungstag der Anmeldung: **23.08.2023**
(21) Anmeldenummer: 22157232.4
(22) Anmeldetag: 17.02.2022
(51) Int. Cl.: G03F 7/20, F21V 29/50, F21V 29/56, F21V 29/74

(54) **PROJEKTIONSVORRICHTUNG**

(71) Anmelder: In-Vision Technologies AG, 2353 Guntramsdorf (AT)
(72) Erfinder: Gamauf, Christoph, 7434 Bernstein (AT); Wannack, Julian, 2521 Trumau (AT); Hieger, Christof, 3142 Perschling (AT)
(74) Vertreter: Patentanwaltskanzlei Matschnig & Forsthuber OG

(57) **Zusammenfassung**

Projektionsvorrichtung (10) für Druckervorrichtungen, insbesondere Vorrichtungen zum 3D-Druck, wobei die Projektionsvorrichtung Folgendes umfasst:
- zumindest eine Lichtquelle (100) und einen Lichtquellen-Träger (200),
- ein Projektionsoptiksystem (300), welches eingerichtet ist, das von der zumindest einen Lichtquelle (100) emittierbare Licht vor die Projektionsvorrichtung (100) zu projizieren, und
- ein Kühlsystem (400) zum Abführen der von der zumindest einen Lichtquelle (100) erzeugten Wärme, wobei das Kühlsystem umfasst:
- ein fluiddichtes Kühlgehäuse (410), welches einen Hohlraum (420) einschließt, wobei das Kühlgehäuse (410) zum Einströmen einer Kühlflüssigkeit in den Hohlraum (420) einen Einlass (410a) und einen von dem Einlass (410a) separaten Auslass (410b) zum Ausströmen der Kühlflüssigkeit aus dem Hohlraum (420) aufweist, wobei der Lichtquellen-Träger (200) zumindest einen Teil des fluiddichten Kühlgehäuses (410) bildet, sodass die in den Hohlraum (420) einströmbare Kühlflüssigkeit die von der zumindest einen Lichtquelle (100) an den Lichtquellen-Träger (200) abgegebene Wärme aufnehmen und durch Abströmen über den Auslass (410b) abtransportieren kann, wobei der Lichtquellen-Träger (200) eine Kühlstruktur (210) aus einer Vielzahl von Rippen (211) aufweist,

wobei die Kühlstruktur (210) an der zweiten Seite (200b) des Lichtquellen-Trägers (200) angeordnet ist und derart in den Hohlraum (420) des Kühlgehäuses (410) ragt, sodass die in den Hohlraum (420) des Kühlgehäuses (410) einströmbare Kühlflüssigkeit zwischen den Rippen (211) durchströmen kann, um die von der zumindest einen Lichtquelle (100) an den Lichtquellen-Träger (200) abgegebene Wärme aufzunehmen und durch Abströmen über den Auslass (410b) abzutransportieren.

## Beschreibung

Die Erfindung betrifft eine Projektionsvorrichtung für Druckervorrichtungen, insbesondere Vorrichtungen zum 3D-Druck und/oder Lithografievorrichtungen, wobei die Projektionsvorrichtung Folgendes umfasst:
- zumindest eine Lichtquelle, welche eingerichtet ist, Licht in Richtung einer Hauptabstrahlrichtung zu emittieren,
- einen Lichtquellen-Träger zum Tragen der zumindest einen Lichtquelle, wobei der Lichtquellen-Träger eine erste Seite und eine der ersten Seite gegenüberliegende zweite Seite aufweist, wobei die zumindest eine Lichtquelle auf der ersten Seite des Lichtquellen-Trägers angeordnet ist, und wobei die zumindest eine Lichtquelle derart mit dem Lichtquellen-Träger thermisch verbunden ist, dass von der zumindest einen Lichtquelle erzeugbare Wärme zumindest teilweise von dem Lichtquellen-Träger aufnehmbar ist,
- ein Projektionsoptiksystem, umfassend zumindest eine Projektionslinse, welche der zumindest einen Lichtquelle in Richtung der Hauptabstrahlrichtung nachgeschaltet ist, und eingerichtet ist, das von der zumindest einen Lichtquelle emittierbare Licht vor die Projektionsvorrichtung zu projizieren, und
- ein Kühlsystem zum Abführen der von der zumindest einen Lichtquelle erzeugten Wärme, wobei das Kühlsystem umfasst:
- ein fluiddichtes Kühlgehäuse, welches einen Hohlraum einschließt, wobei das Kühlgehäuse zum Einströmen einer Kühlflüssigkeit in den Hohlraum einen Einlass und einen von dem Einlass separaten Auslass zum Ausströmen der Kühlflüssigkeit aus dem Hohlraum aufweist,
wobei die Kühlflüssigkeit, welche über den Einlass in den Hohlraum einströmbar ist, und über den Auslass aus dem Hohlraum ausströmbar ist, entlang einer Strömungsrichtung von dem Einlass zum Auslass im Hohlraum des Kühlgehäuses strömen kann,
wobei der Lichtquellen-Träger zumindest einen Teil des fluiddichten Kühlgehäuses bildet, sodass die zweite Seite des Lichtquellen-Trägers zumindest abschnittsweise den Hohlraum des Kühlgehäuses begrenzt, sodass die in den Hohlraum einströmbare Kühlflüssigkeit die von der zumindest einen Lichtquelle an den Lichtquellen-Träger abgegebene Wärme aufnehmen und durch Abströmen über den Auslass abtransportieren kann.

Ferner betrifft die Erfindung eine Druckervorrichtung umfassend zumindest eine erfindungsgemäße Projektionsvorrichtung.

Bei Projektionsvorrichtung für Druckervorrichtungen, insbesondere für den 3D-Druck, sind leistungsstarke Lichtquellen, beispielsweise Hochleistungs-LED, erforderlich. Der Einsatz solcher Lichtquellen erfordert ein Kühlsystem, das in der Lage ist, die von der Lichtquelle im Betrieb erzeugte Wärme effizient und ausreichend abzuführen. Hierbei haben sich Kühlsysteme etabliert, welche eine Kühlflüssigkeit verwenden, um die erzeugte Wärme abzuführen.

Allerdings sind den Kühlsystemen aus dem Stand der Technik Grenzen gesetzt, sodass Lichtquellen ab einer gewissen Leistungsstärke bzw. Leuchtstärke nicht mehr zureichend gekühlt werden können.

Es ist eine Aufgabe der Erfindung eine verbesserte Projektionsvorrichtung bereitzustellen.

Diese Aufgabe wird dadurch gelöst, dass der Lichtquellen-Träger eine Kühlstruktur aufweist, welche Kühlstruktur aus einer Vielzahl von Rippen ausgebildet ist, wobei sich je eine Rippe entlang einer Erstreckungs-Ebene erstreckt,
wobei die Kühlstruktur an der zweiten Seite des Lichtquellen-Trägers angeordnet ist und derart in den Hohlraum des Kühlgehäuses ragt, sodass die in den Hohlraum des Kühlgehäuses einströmbare Kühlflüssigkeit zwischen den Rippen durchströmen kann, um die von der zumindest einen Lichtquelle an den Lichtquellen-Träger abgegebene Wärme aufzunehmen und durch Abströmen über den Auslass abzutransportieren.

Insbesondere kann vorgesehen sein, dass die Rippen derart zueinander angeordnet sind, dass die Erstreckungs-Ebenen der Rippen parallel zueinander angeordnet sind.

Weiters kann vorgesehen sein, dass der Abstand zwischen unmittelbar benachbarten Erstreckungs-Ebenen der Rippen gleich ist.

Insbesondere kann vorgesehen sein, dass die zumindest eine Lichtquelle als zumindest eine Leuchtdiode ausgebildet ist.

Weiters kann vorgesehen sein, dass die Kühlstruktur gegenüberliegend der zumindest einen Lichtquelle auf der zweiten Seite des Lichtquellen-Trägers angeordnet ist.

Insbesondere kann vorgesehen sein, dass die Erstreckungs-Ebenen der Rippen parallel zur Strömungsrichtung der Kühlflüssigkeit ausgerichtet sind.

Weiters kann vorgesehen sein, dass die Erstreckungs-Ebenen der Rippen quer zur Strömungsrichtung der Kühlflüssigkeit ausgerichtet sind.

Insbesondere kann vorgesehen sein, dass der Lichtquellen-Träger aus Metall gebildet ist.

Weiters kann vorgesehen sein, dass der Lichtquellen-Träger aus Kupfer gebildet ist.

Insbesondere kann vorgesehen sein, dass die Kühlstruktur mittels Fräsverfahren einstückig mit dem Lichtquellen-Träger hergestellt ist.

Weiters kann vorgesehen sein, dass die Kühlflüssigkeit Wasser ist.

Insbesondere kann vorgesehen sein, dass die Rippen der Kühlstruktur jeweils eine Höhe von 1,5 bis 2,5 mm, vorzugsweise eine Höhe von 2mm, und eine Dicke von 2,5 bis 3,5 mm, vorzugsweise eine Dicke von 3,2 mm aufweisen.

Es kann vorgesehen sein, dass die Rippen der Kühlstruktur jeweils eine Länge, abhängig von der Größe der Lichtquelle, von 5 bis 20 mm aufweisen.

Weiters kann vorgesehen sein, dass das Kühlsystem eine Kühlflüssigkeit umfasst, welche über den Einlass in den Hohlraum einströmbar ist, und über den Auslass aus dem Hohlraum ausströmbar ist, wobei die Kühlflüssigkeit entlang einer Strömungsrichtung von dem Einlass zum Auslass im Hohlraum des Kühlgehäuses strömt.

Es kann vorgesehen sein, dass das Kühlsystem ein Strömungsleitelement umfasst, welches derart im Hohlraum des Kühlgehäuses angeordnet ist, um ein gezieltes Durchströmen der Kühlflüssigkeit zwischen den Rippen der Kühlstruktur zu ermöglichen. Das Strömungsleitelement kann dabei als Blech ausgebildet sein, wobei das Blech eine Ausnehmung aufweist, welche das Blech vollständig durchsetzt. Das Blech kann in seiner Erstreckung flächig ausgebildet und innerhalb des Hohlraums an der zweiten Seite des Lichtquellen-Trägers derart befestigt sein, dass die Kühlstruktur die Ausnehmung des Blechs durchsetzt, wobei vorzugsweise die Länge und Breite der Ausnehmung der Länge und Breite der Kühlstruktur entspricht.

Die Aufgabe wird ebenso gelöst durch eine Druckervorrichtung, insbesondere für den 3D-Druck, umfassend zumindest eine Projektionsvorrichtung gemäß der Erfindung.

Nachfolgend wird die Erfindung anhand von beispielhaften Zeichnungen näher erläutert. Hierbei zeigt
Fig. 1 eine schematische Darstellung einer beispielhaften Projektionsvorrichtung in einem Querschnitt, wobei die Projektionsvorrichtung eine Lichtquelle, welche auf einem Lichtquellen-Träger angeordnet ist, ein der Lichtquelle zugeordnetes Kühlsystem und eine Projektionsoptiksystem umfasst, wobei das Kühlsystem eine Kühlstruktur aus einer Vielzahl an Rippen aufweist umfasst,
Fig. 2 eine perspektivische Ansicht einer beispielhaften Rippe der Kühlstruktur der Projektionsvorrichtung aus Fig. 1, wobei sich die Rippe entlang einer Erstreckungsebene erstreckt,
Fig. 3 eine perspektivische Ansicht der Rückseite des Lichtquellen-Trägers, wobei die Kühlstruktur ersichtlich ist, welche an dem Lichtquellen-Träger angeordnet ist, und
Fig. 4 eine perspektivische Ansicht eines Abschnitts der Projektionsvorrichtung, wobei das Kühlsystem zumindest teilweise zu sehen ist.

In den folgenden Figuren bezeichnen - sofern nicht anders angegeben - gleiche Bezugszeichen gleiche Merkmale.

Die Erfindung ist nicht auf die gezeigten Ausführungsformen beschränkt, sondern durch den gesamten Schutzumfang der Ansprüche definiert. Auch können einzelne Aspekte der Erfindung bzw. der Ausführungsformen aufgegriffen und miteinander kombiniert werden. Etwaige Bezugszeichen in den Ansprüchen sind beispielhaft und dienen nur der einfacheren Lesbarkeit der Ansprüche, ohne diese einzuschränken.

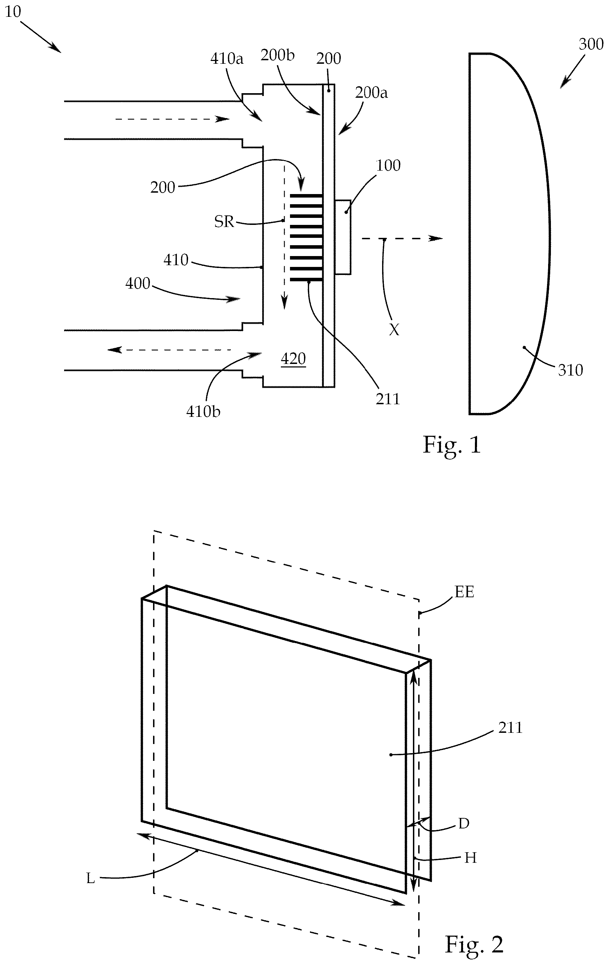

Fig. 1 zeigt eine beispielhafte Projektionsvorrichtung 10 für Druckervorrichtungen, insbesondere Vorrichtungen zum 3D-Druck, wobei die Projektionsvorrichtung 10 eine Lichtquelle 100 umfasst, welche eingerichtet ist, Licht in Richtung einer Hauptabstrahlrichtung X zu emittieren. Die Lichtquelle 100 ist im gezeigten Beispiel als Leuchtdiode bzw. LED ausgebildet.

Die Projektionsvorrichtung **10** umfasst weiters einen Lichtquellen-Träger **200** zum Tragen der zumindest einen Lichtquelle **100**, wobei der Lichtquellen-Träger **200** eine erste Seite **200a** und eine der ersten Seite **200a** gegenüberliegende zweite Seite **200b** aufweist, wobei die zumindest eine Lichtquelle **100** auf der ersten Seite **200a** des Lichtquellen-Trägers **200** angeordnet ist, und wobei die zumindest eine Lichtquelle **100** derart mit dem Lichtquellen-Träger **200** thermisch verbunden ist, dass von der zumindest einen Lichtquelle **100** erzeugbare Wärme zumindest teilweise von dem Lichtquellen-Träger **200** aufnehmbar ist.

Ferner umfasst die Projektionsvorrichtung **10** ein Projektionsoptiksystem **300**, umfassend zumindest eine Projektionslinse **310**, welche der zumindest einen Lichtquelle **100** in Richtung der Hauptabstrahlrichtung **X** nachgeschaltet ist, und eingerichtet ist, das von der zumindest einen Lichtquelle **100** emittierbare Licht vor die Projektionsvorrichtung **100** zu projizieren.

Zusätzlich umfasst die Projektionsvorrichtung **10** ein Kühlsystem **400** zum Abführen der von der zumindest einen Lichtquelle **100** erzeugten Wärme, wobei das Kühlsystem ein fluiddichtes Kühlgehäuse **410** umfasst, welches einen Hohlraum **420** einschließt, wobei das Kühlgehäuse **410** zum Einströmen einer Kühlflüssigkeit in den Hohlraum **420** einen Einlass **410a** und einen von dem Einlass **410a** separaten Auslass **410b** zum Ausströmen der Kühlflüssigkeit aus dem Hohlraum **420** aufweist.

Das dargestellte Kühlsystem **400** umfasst ferner eine Kühlflüssigkeit, beispielsweise Wasser, welche über den Einlass **410a** in den Hohlraum **420** einströmbar ist, und über den Auslass **410b** aus dem Hohlraum **420** ausströmbar ist, entlang einer Strömungsrichtung **SR** von dem Einlass **410a** zum Auslass **410b** im Hohlraum **420** des Kühlgehäuses **410** strömen kann.

Der Lichtquellen-Träger **200** bildet zumindest einen Teil des fluiddichten Kühlgehäuses **410** bildet, sodass die zweite Seite **200b** des Lichtquellen-Trägers **200** zumindest abschnittsweise den Hohlraum **420** des Kühlgehäuses **410** begrenzt, sodass die in den Hohlraum **420** einströmbare Kühlflüssigkeit die von der zumindest einen Lichtquelle **100** an den Lichtquellen-Träger **200** abgegebene Wärme aufnehmen und durch Abströmen über den Auslass **410b** abtransportieren kann.

Der Lichtquellen-Träger **200** weist eine Kühlstruktur **210** auf, welche Kühlstruktur **210** aus einer Vielzahl von Rippen **211** ausgebildet ist, wobei sich je eine Rippe **211** entlang einer Erstreckungs-Ebene **EE** erstreckt.

**Fig. 2** zeigt hierzu exemplarisch eine Rippe **211**, welche sich entlang einer ErstreckungsEbene **EE** erstreckt. Eine gewisse Dicke der Rippe **211** ist hierbei zulässig.

In dem gezeigten Beispiel sind die Rippen **211** derart zueinander angeordnet, dass die Erstreckungs-Ebenen **EE** der Rippen **211** parallel zueinander angeordnet sind, wobei der Abstand zwischen unmittelbar benachbarten Erstreckungs-Ebenen **EE** der Rippen **211** gleich ist. Die Rippen **211** der Kühlstruktur **200** können jeweils eine Höhe **H** von 1,5 bis 2,5 mm, vorzugsweise eine Höhe **H** von 2mm, und eine Dicke **D** von 2,5 bis 3,5 mm, vorzugsweise eine Dicke **D** von 3,2 mm aufweisen, und eine Länge **L** - abhängig von der Größe der Lichtquelle - von 5 bis 20 mm aufweisen.

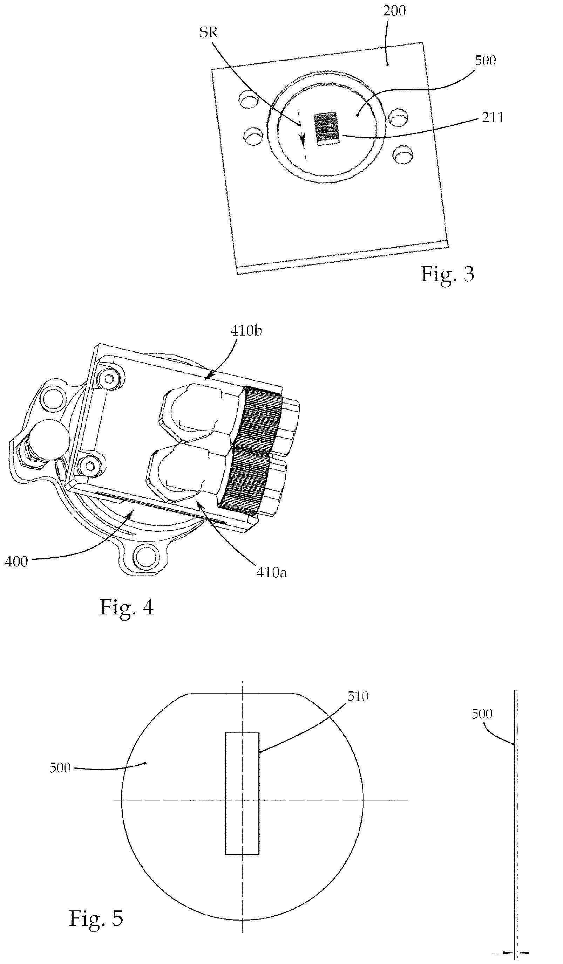

Im gezeigten Beispiel in den Figuren sind die Erstreckungs-Ebenen **EE** der Rippen **211** orthogonal zur Strömungsrichtung **SR** der Kühlflüssigkeit ausgerichtet, wie beispielsweise in **Fig. 3** gezeigt ist. **Fig. 3** zeigt die Rückseite in Richtung der Hauptabstrahlrichtung **X** des Kühlgehäuses und die zweite Seite des Lichtquellen-Trägers **200**, auf welcher die Kühlstruktur angeordnet ist.

Ferner umfasst das Kühlsystem **400** ein Strömungsleitelement **500**, wie in **Fig. 3** zu sehen ist, wobei das Strömungsleitelement **500** derart im Hohlraum **420** des Kühlgehäuses **410** angeordnet ist, um ein gezieltes Durchströmen der Kühlflüssigkeit zwischen den Rippen **211** der Kühlstruktur **210** zu ermöglichen.

Das Strömungsleitelement **500** ist dabei als Blech ausgebildet, wobei das Blech eine Ausnehmung **510** aufweist, welche das Blech vollständig durchsetzt. Das Blech ist in seiner Erstreckung flächig ausgebildet und innerhalb des Hohlraums **420** an der zweiten Seite **200b** des Lichtquellen-Trägers **200** derart befestigt, dass die Kühlstruktur **210** die Ausnehmung **510** des Blechs durchsetzt, wobei die Länge und Breite der Ausnehmung **510** der Länge und Breite der Kühlstruktur **210** entspricht, sodass die Kühlstruktur **210** passgenau in der Ausnehmung **510** aufgenommen ist.

Die Rippen **211** können jedoch auch parallel zur Strömungsrichtung **SR** ausgerichtet sein.

Die Kühlstruktur **210** ist an der zweiten Seite **200b** des Lichtquellen-Trägers **200** angeordnet und ragt derart in den Hohlraum **420** des Kühlgehäuses **410**, sodass die in den Hohlraum **420** des Kühlgehäuses **410** einströmbare Kühlflüssigkeit zwischen den Rippen **211** durchströmen kann, um die von der zumindest einen Lichtquelle **100** an den Lichtquellen-Träger **200** abgegebene Wärme aufzunehmen und durch Abströmen über den Auslass **410b** abzutransportieren.

Die Kühlstruktur **210** ist dabei gegenüberliegend der Lichtquelle **100** auf der zweiten Seite **200b** des Lichtquellen-Trägers **200** angeordnet.

Der Lichtquellen-Träger **200** ist aus Kupfer hergestellt, wobei die Kühlstruktur **210** mittels Fräsverfahren einstückig mit dem Lichtquellen-Träger **200** hergestellt ist.

**Fig. 4** zeigt eine perspektivische Rückansicht eines geschlossenen Kühlgehäuses **410**, wobei ein Anschluss zum Zuführen der Kühlflüssigkeit in den Einlass **410a** und ein Anschluss zum Abführen der Kühlflüssigkeit aus dem Auslass **410b** ersichtlich ist.

**LISTE DER BEZUGSZEICHEN**

| | |
|---|---|
| Projektionsvorrichtung | 10 |
| Lichtquelle | 100 |
| Lichtquellen-Träger | 200 |
| Erste Seite | 200a |
| Zweite Seite | 200b |
| Kühlstruktur | 210 |
| Rippen | 211 |
| Projektionsoptiksystem | 300 |
| Kühlsystem | 400 |
| Kühlgehäuse | 410 |
| Einlass | 410a |
| Auslass | 410b |
| Hohlraum | 420 |
| Strömungsleitelement | 500 |
| Ausnehmung | 510 |
| Erstreckungs-Ebene | EE |
| Höhe | H |
| Länge | L |
| Dicke | D |
| Strömungsrichtung | SR |
| Hauptabstrahlrichtung | X |

## Patentansprüche

1. Projektionsvorrichtung (10) für Druckervorrichtungen, insbesondere Vorrichtungen zum 3D-Druck und/oder Lithografievorrichtungen, wobei die Projektionsvorrichtung Folgendes umfasst:
- zumindest eine Lichtquelle (100), welche eingerichtet ist, Licht in Richtung einer Hauptabstrahlrichtung (X) zu emittieren,
- einen Lichtquellen-Träger (200) zum Tragen der zumindest einen Lichtquelle (100), wobei der Lichtquellen-Träger (200) eine erste Seite (200a) und eine der ersten Seite (200a) gegenüberliegende zweite Seite (200b) aufweist, wobei die zumindest eine Lichtquelle (100) auf der ersten Seite (200a) des Lichtquellen-Trägers (200) angeordnet ist, und wobei die zumindest eine Lichtquelle (100) derart mit dem Lichtquellen-Träger (200) thermisch verbunden ist, dass von der zumindest einen Lichtquelle (100) erzeugbare Wärme zumindest teilweise von dem Lichtquellen-Träger (200) aufnehmbar ist,
- ein Projektionsoptiksystem (300), umfassend zumindest eine Projektionslinse (310), welche der zumindest einen Lichtquelle (100) in Richtung der Hauptabstrahlrichtung (X) nachgeschaltet ist, und eingerichtet ist, das von der zumindest einen Lichtquelle (100) emittierbare Licht vor die Projektionsvorrichtung (100) zu projizieren, und
- ein Kühlsystem (400) zum Abführen der von der zumindest einen Lichtquelle (100) erzeugten Wärme, wobei das Kühlsystem umfasst:
- ein fluiddichtes Kühlgehäuse (410), welches einen Hohlraum (420) einschließt, wobei das Kühlgehäuse (410) zum Einströmen einer Kühlflüssigkeit in den Hohlraum (420) einen Einlass (410a) und einen von dem Einlass (410a) separaten Auslass (410b) zum Ausströmen der Kühlflüssigkeit aus dem Hohlraum (420) aufweist,
wobei die Kühlflüssigkeit, welche über den Einlass (410a) in den Hohlraum (420) einströmbar ist, und über den Auslass (410b) aus dem Hohlraum (420) ausströmbar ist, entlang einer Strömungsrichtung (SR) von dem Einlass (410a) zum Auslass (410b) im Hohlraum (420) des Kühlgehäuses (410) strömen kann,
wobei der Lichtquellen-Träger (200) zumindest einen Teil des fluiddichten Kühlgehäuses (410) bildet, sodass die zweite Seite (200b) des Lichtquellen-Trägers (200) zumindest abschnittsweise den Hohlraum (420) des Kühlgehäuses (410) begrenzt, sodass die in den Hohlraum (420) einströmbare Kühlflüssigkeit die von der zumindest einen Lichtquelle (100) an den Lichtquellen-Träger (200) abgegebene Wärme aufnehmen und durch Abströmen über den Auslass (410b) abtransportieren kann,
**dadurch gekennzeichnet, dass**
der Lichtquellen-Träger (200) eine Kühlstruktur (210) aufweist, welche Kühlstruktur (210) aus einer Vielzahl von Rippen (211) ausgebildet ist, wobei sich je eine Rippe (211) entlang einer Erstreckungs-Ebene (EE) erstreckt,
wobei die Kühlstruktur (210) an der zweiten Seite (200b) des Lichtquellen-Trägers (200) angeordnet ist und derart in den Hohlraum (420) des Kühlgehäuses (410) ragt, sodass die in den Hohlraum (420) des Kühlgehäuses (410) einströmbare Kühlflüssigkeit zwischen den Rippen (211) durchströmen kann, um die von der zumindest einen Lichtquelle (100) an den Lichtquellen-Träger (200) abgegebene Wärme aufzunehmen und durch Abströmen über den Auslass (410b) abzutransportieren.

2. Projektionsvorrichtung nach Anspruch 1, **wobei** die Rippen (211) derart zueinander angeordnet sind, dass die Erstreckungs-Ebenen (EE) der Rippen (211) parallel zueinander angeordnet sind.

3. Projektionsvorrichtung nach Anspruch 2, **wobei** der Abstand zwischen unmittelbar benachbarten Erstreckungs-Ebenen (EE) der Rippen (211) gleich ist.

4. Projektionsvorrichtung nach einem der Ansprüche 1 bis 3, **wobei** die zumindest eine Lichtquelle (100) als zumindest eine Leuchtdiode ausgebildet ist.

5. Projektionsvorrichtung nach einem der Ansprüche 1 bis 4, **wobei** die Kühlstruktur (210) gegenüberliegend der zumindest einen Lichtquelle (100) auf der zweiten Seite (200b) des Lichtquellen-Trägers (200) angeordnet ist.

6. Projektionsvorrichtung nach einem der Ansprüche 1 bis 5, **wobei** die Erstreckungs-Ebenen (EE) der Rippen (211) parallel zur Strömungsrichtung (SR) der Kühlflüssigkeit ausgerichtet sind.

7. Projektionsvorrichtung nach einem der Ansprüche 1 bis 5, **wobei** die Erstreckungs-Ebenen (EE) der Rippen (211) quer zur Strömungsrichtung (SR) der Kühlflüssigkeit ausgerichtet sind.

8. Projektionsvorrichtung nach einem der Ansprüche 1 bis 7, **wobei** der Lichtquellen-Träger (200) aus Metall gebildet ist.

9. Projektionsvorrichtung nach Anspruch 8, **wobei** der Lichtquellen-Träger (200) aus Kupfer gebildet ist.

10. Projektionsvorrichtung nach einem der Ansprüche 1 bis 9, **wobei** die Kühlstruktur (210) mittels Fräsverfahren einstückig mit dem Lichtquellen-Träger (200) hergestellt ist.

11. Projektionsvorrichtung nach einem der Ansprüche 1 bis 10, **wobei** die Kühlflüssigkeit Wasser ist.

12. Projektionsvorrichtung nach einem der Ansprüche 1 bis 11, **wobei** die Rippen (211) der Kühlstruktur (200) jeweils eine Höhe (H) von 1,5 bis 2,5 mm, vorzugsweise eine Höhe (H) von 2 mm, und eine Dicke (D) von 2,5 bis 3,5 mm, vorzugsweise eine Dicke (D) von 3,2 mm aufweisen, und eine Länge (L) von 5 bis 20 mm aufweisen

13. Projektionsvorrichtung nach einem der Ansprüche 1 bis 12, **wobei** das Kühlsystem eine Kühlflüssigkeit umfasst, welche über den Einlass (410a) in den Hohlraum (420) einströmbar ist, und über den Auslass (410b) aus dem Hohlraum (420) ausströmbar ist, wobei die Kühlflüssigkeit entlang einer Strömungsrichtung (SR) von dem Einlass (410a) zum Auslass (410b) im Hohlraum (420) des Kühlgehäuses (410) strömt.

14. Projektionsvorrichtung nach einem der Ansprüche 1 bis 13, **wobei** das Kühlsystem ein Strömungsleitelement (500) umfasst, welches derart im Hohlraum (420) des Kühlgehäuses (410) angeordnet ist, um ein gezieltes Durchströmen der Kühlflüssigkeit zwischen den Rippen (211) der Kühlstruktur (210) zu ermöglichen.

15. Druckervorrichtung, insbesondere für den 3D-Druck und/oder Lithografie, umfassend zumindest eine Projektionsvorrichtung gemäß einem der Ansprüche 1 bis 14.

## Geänderte Patentansprüche

### Geänderte Patentansprüche gemäss Regel 137(2) EPÜ.

1. Projektionsvorrichtung (10) für Druckervorrichtungen, insbesondere Vorrichtungen zum 3D-Druck und/oder Lithografievorrichtungen, wobei die Projektionsvorrichtung Folgendes umfasst:
- zumindest eine Lichtquelle (100), welche eingerichtet ist, Licht in Richtung einer Hauptabstrahlrichtung (X) zu emittieren,
- einen Lichtquellen-Träger (200) zum Tragen der zumindest einen Lichtquelle (100), wobei der Lichtquellen-Träger (200) eine erste Seite (200a) und eine der ersten Seite (200a) gegenüberliegende zweite Seite (200b) aufweist, wobei die zumindest eine Lichtquelle (100) auf der ersten Seite (200a) des Lichtquellen-Trägers (200) angeordnet ist, und wobei die zumindest eine Lichtquelle (100) derart mit dem Lichtquellen-Träger (200) thermisch verbunden ist, dass von der zumindest einen Lichtquelle (100) erzeugbare Wärme zumindest teilweise von dem Lichtquellen-Träger (200) aufnehmbar ist,
- ein Projektionsoptiksystem (300), umfassend zumindest eine Projektionslinse (310), welche der zumindest einen Lichtquelle (100) in Richtung der Hauptabstrahlrichtung (X) nachgeschaltet ist, und eingerichtet ist, das von der zumindest einen Lichtquelle (100) emittierbare Licht vor die Projektionsvorrichtung (100) zu projizieren, und
- ein Kühlsystem (400) zum Abführen der von der zumindest einen Lichtquelle (100) erzeugten Wärme, wobei das Kühlsystem umfasst:
- ein fluiddichtes Kühlgehäuse (410), welches einen Hohlraum (420) einschließt, wobei das Kühlgehäuse (410) zum Einströmen einer Kühlflüssigkeit in den Hohlraum (420) einen Einlass (410a) und einen von dem Einlass (410a) separaten Auslass (410b) zum Ausströmen der Kühlflüssigkeit aus dem Hohlraum (420) aufweist,
wobei die Kühlflüssigkeit, welche über den Einlass (410a) in den Hohlraum (420) einströmbar ist, und über den Auslass (410b) aus dem Hohlraum (420) ausströmbar ist, entlang einer Strömungsrichtung (SR) von dem Einlass (410a) zum Auslass (410b) im Hohlraum (420) des Kühlgehäuses (410) strömen kann,
wobei der Lichtquellen-Träger (200) zumindest einen Teil des fluiddichten Kühlgehäuses (410) bildet, sodass die zweite Seite (200b) des Lichtquellen-Trägers (200) zumindest abschnittsweise den Hohlraum (420) des Kühlgehäuses (410) begrenzt, sodass die in den Hohlraum (420) einströmbare Kühlflüssigkeit die von der zumindest einen Lichtquelle (100) an den Lichtquellen-Träger (200) abgegebene Wärme aufnehmen und durch Abströmen über den Auslass (410b) abtransportieren kann,
wobei der Lichtquellen-Träger (200) eine Kühlstruktur (210) aufweist, welche Kühlstruktur (210) aus einer Vielzahl von Rippen (211) ausgebildet ist, wobei sich je eine Rippe (211) entlang einer Erstreckungs-Ebene (EE) erstreckt,
wobei die Kühlstruktur (210) an der zweiten Seite (200b) des Lichtquellen-Trägers (200) angeordnet ist und derart in den Hohlraum (420) des Kühlgehäuses (410) ragt, sodass die in den Hohlraum (420) des Kühlgehäuses (410) einströmbare Kühlflüssigkeit zwischen den Rippen (211) durchströmen kann, um die von der zumindest einen Lichtquelle (100) an den Lichtquellen-Träger (200) abgegebene Wärme aufzunehmen und durch Abströmen über den Auslass (410b) abzutransportieren,
**dadurch gekennzeichnet, dass**
das Kühlsystem ein Strömungsleitelement (500) umfasst, welches derart im Hohlraum (420) des Kühlgehäuses (410) angeordnet ist, um ein gezieltes Durchströmen der Kühlflüssigkeit zwischen den Rippen (211) der Kühlstruktur (210) zu ermöglichen.

2. Projektionsvorrichtung nach Anspruch 1, **wobei** die Rippen (211) derart zueinander angeordnet sind, dass die Erstreckungs-Ebenen (EE) der Rippen (211) parallel zueinander angeordnet sind.

3. Projektionsvorrichtung nach Anspruch 2, **wobei** der Abstand zwischen unmittelbar benachbarten Erstreckungs-Ebenen (EE) der Rippen (211) gleich ist.

4. Projektionsvorrichtung nach einem der Ansprüche 1 bis 3, **wobei** die zumindest eine Lichtquelle (100) als zumindest eine Leuchtdiode ausgebildet ist.

5. Projektionsvorrichtung nach einem der Ansprüche 1 bis 4, **wobei** die Kühlstruktur (210) gegenüberliegend der zumindest einen Lichtquelle (100) auf der zweiten Seite (200b) des Lichtquellen-Trägers (200) angeordnet ist.

6. Projektionsvorrichtung nach einem der Ansprüche 1 bis 5, **wobei** die Erstreckungs-Ebenen (EE) der Rippen (211) parallel zur Strömungsrichtung (SR) der Kühlflüssigkeit ausgerichtet sind.

7. Projektionsvorrichtung nach einem der Ansprüche 1 bis 5, **wobei** die Erstreckungs-Ebenen (EE) der Rippen (211) quer zur Strömungsrichtung (SR) der Kühlflüssigkeit ausgerichtet sind.

8. Projektionsvorrichtung nach einem der Ansprüche 1 bis 7, **wobei** der Lichtquellen-Träger (200) aus Metall gebildet ist.

9. Projektionsvorrichtung nach Anspruch 8, **wobei** der Lichtquellen-Träger (200) aus Kupfer gebildet ist.

10. Projektionsvorrichtung nach einem der Ansprüche 1 bis 9, **wobei** die Kühlstruktur (210) mittels Fräsverfahren einstückig mit dem Lichtquellen-Träger (200) hergestellt ist.

11. Projektionsvorrichtung nach einem der Ansprüche 1 bis 10, **wobei** die Kühlflüssigkeit Wasser ist.

12. Projektionsvorrichtung nach einem der Ansprüche 1 bis 11, **wobei** die Rippen (211) der Kühlstruktur (200) jeweils eine Höhe (H) von 1,5 bis 2,5 mm, vorzugsweise eine Höhe (H) von 2 mm, und eine Dicke (D) von 2,5 bis 3,5 mm, vorzugsweise eine Dicke (D) von 3,2 mm aufweisen, und eine Länge (L) von 5 bis 20 mm aufweisen

13. Projektionsvorrichtung nach einem der Ansprüche 1 bis 12, **wobei** das Kühlsystem eine Kühlflüssigkeit umfasst, welche über den Einlass (410a) in den Hohlraum (420) einströmbar ist, und über den Auslass (410b) aus dem Hohlraum (420) ausströmbar ist, wobei die Kühlflüssigkeit entlang einer Strömungsrichtung (SR) von dem Einlass (410a) zum Auslass (410b) im Hohlraum (420) des Kühlgehäuses (410) strömt.

14. Druckervorrichtung, insbesondere für den 3D-Druck und/oder Lithografie, umfassend zumindest eine Projektionsvorrichtung gemäß einem der Ansprüche 1 bis 13.
